# EUROPÄISCHE PATENTSCHRIFT

(11) **EP 1 079 392 B1**
(45) Veröffentlichungstag und Bekanntmachung des Hinweises auf die Patenterteilung: **11.07.2007**
(21) Anmeldenummer: 00117413.5
(22) Anmeldetag: 11.08.2000
(51) Int. Cl.: G11C 7/10, H04H 1/00

(54) **Vorrichtung für die Aufzeichnung und Wiedergabe von digitalen Tonsignalen für Verwendung in einem Kraftfahrzeug**
System for recording and reproducing digital audio signals, for use in a car
Système pour l'enregistrement et pour la reproduction de signaux audionumériques, pour utilisation dans une automobile

(30) Priorität: 27.08.1999 DE 19940905
(43) Veröffentlichungstag der Anmeldung: 28.02.2001
(73) Patentinhaber: Harman Becker Automotive Systems GmbH, 76307 Karlsbad (DE)
(72) Erfinder: Wietzke, Joachim, Dr.-Ing., 76228 Karlsruhe (DE); Lappe, Dirk, Dipl.-Ing., 31174 Dinklar (DE); Kohl, Wolfram, 75210 Keltern (DE)
(74) Vertreter: Patentanwälte Westphal, Mussgnug & Partner

(56) Entgegenhaltungen:
- EP-A- 0 831 608
- WO-A-98/17009
- US-A- 5 633 837

## Beschreibung

Die Erfindung betrifft eine Wiedergabevorrichtung für Compact-Discs in einem Kraftfahrzeug.

In Kraftfahrzeugen werden heutzutage üblicherweise Rundfunkempfangsgeräte sowie Compact-Disc-Abspielgeräte eingesetzt. Der Vorteil von Compact-Disc-Abspielgeräten gegenüber Rundfunkempfängern liegt vor allem darin, daß die akustischen Darbietungen wesentlich besser dem eigenen Geschmack entsprechend ausgewählt werden können. Je abwechslungsreicher die Darbietungen sein sollen, desto mehr Compact-Discs müssen allerdings im Fahrzeug untergebracht werden. Dabei können zwar Mehrfach-Compact-Disc-Abspielgeräte (sogenannte Compact-Disc-Wechsler) die Handhabung wesentlich erleichtern, jedoch sind weiterhin eine Vielzahl von Compact-Discs im Fahrzeug erforderlich. Demgegenüber ist es bei Rundfunkempfang vorteilhafterweise nicht notwendig, entsprechende Tonträger beispielsweise in Form von Compact-Discs bereitzuhalten, jedoch hat der Anwender auch nicht die umfangreichen Auswahlmöglichkeiten.

Die Patentschrift US 5,633,837 und die Patentschrift EP 0 831 608 A1 offenbaren eine Tonwiedergabe- und Tonaufzeichnungsvorrichtung mit einer Signalquelle zum Erzeugen digitaler Signale, einem mit der Signalquelle verbundenen Massenspeicher zum Speichern digitaler Signale, einem Bedienteil zur Mensch-Maschine-Kommunikation und einer Ablaufsteuerung zum Steuern der Signalquelle und des Massenspeichers in Abhängigkeit von in das Bedienteil eingegebenen Informationen derart, daß beim Betrieb der Signalquelle die von dieser erzeugten digitalen Signale in dem Massenspeicher gespeichert werden und dass die Signale aus der Speicherquelle oder aus dem Massenspeicher mittels einer akustischen und/oder optischen Ausgabeeinheit ausgegeben werden. Die US 5,633,837 zeigt dabei insbesondere eine Vorrichtung, die ein kontinuierliches Mitschneiden von Radiosendungen in einen Festspeicher erlaubt, wobei dann der Inhalt des Festspeichers auf ein Tonband oder eine Compact-Disc übertragen werden kann. Es kann darüber hinaus auch entweder der Massenspeicher oder die Signalquelle ausgelesen werden.

Die EP 0 831 608 A2 beschreibt eine Vorrichtung, durch die ein Zuhörer den Inhalt eines empfangenen Radioprogramms festlegen kann, in dem er aus gespeicherten Programminhalten auswählt.

In jüngster Zeit sind Abspielgeräte auf den Markt gekommen, die über einen fest eingebauten Massenspeicher verfügen und die beispielsweise über das Internet mit den gewünschten Darbietungen bespielt werden. Der Vorteil dieser Anordnung ist insbesondere darin zu sehen, daß eine relativ einfache Verfügbarkeit wie bei einem herkömmlichen Rundfunkempfänger erreicht wird und zusätzlich die freie Auswahlmöglichkeit eines Compact-Disc-Abspielgerätes gegeben ist. Jedoch ist ein Einsatz eines derartigen Gerätes in einem Kraftfahrzeug schon allein dadurch begrenzt, daß das Kraftfahrzeug nicht ohne weiteres an das Internet angeschlossen werden kann. Anderenfalls ist aber wiederum ein Austausch von Datenträgern in gleicher Weise wie bei Compact-Discs erforderlich.

Aufgabe der Erfindung ist es daher, eine Wiedergabevorrichtung für ein Kraftfahrzeug anzugeben, bei der Handhabung und Anwendungsvielfalt verbessert sind.

Die Aufgabe wird durch eine Wiedergabevorrichtung gemäß Patentanspruch 1 gelöst. Ausgestaltungen und Weiterbildungen des Erfindungsgedankens sind Gegenstand von Unteransprüchen.

Vorteil der Erfindung ist es, daß parallel zum Abspielen einer Compact-Disc diese kontrolliert in einem Massenspeicher abgelegt werden kann, so daß beim Wunsch, den Inhalt der Compact-Disc erneut abzuhören, diese nicht mehr im Fahrzeug vorrätig sein muß. Dadurch wird eine gleichzeitige Mehrfachnutzung eines Compact-Disc-Abspielgerätes wie zum Beispiel sowohl als Tonwiedergabe- als auch Datensichtgerät ermöglicht. Erreicht wird dies insbesondere durch eine Tonwiedergabe- und Tonaufzeichnungsvorrichtung für ein Kraftfahrzeug mit einer Compact-Disc-Abspieleinheit zum Erzeugen digitaler Signale, einem mit der Compact-Disc-Abspieleinheit verbundenen Massenspeicher zum Speichern digitaler Signale, einem Bedienteil zur Mensch-Maschine-Kommunikation und einer Ablaufsteuerung zum Steuern der Compact-Disc-Abspieleinheit und des Massenspeichers in Abhängigkeit von in das Bedienteil eingegebenen Informationen. Dabei werden beim Betrieb der Compact-Disc-Abspieleinheit von dieser erzeugte Signale in dem Massenspeicher gespeichert. Die Signale direkt von der Compact-Disc-Abspieleinheit oder die gespeicherten Signale aus dem Massenspeicher werden schließlich mittels einer akustischen Ausgabeeinheit ausgegeben.

Es ist folglich möglich, die Compact-Disc-Abspieleinheit abzuhören und gleichzeitig deren Signale im Massenspeicher für einen späteren Gebrauch abzulegen. Es können aber auch alternativ die Signale der Compact-Disc-Abspielquelle zunächst in den Massenspeicher übertragen werden und dann die Compact-Disc-Abspieleinheit und/oder der Massenspeicher mittels der akustischen Ausgabeeinheit abgehört werden.

Es werden dabei die Signale der Compact-Disc-Abspieleinheit zunächst in den Massenspeicher übertragen, diese gespeicherten Signale dann mittels der akustischen Ausgabeeinheit aus dem Massenspeicher ausgegeben und weitere Signale der Compact-Disc-Abspieleinheit (zum Beispiel andere Compact-Disc) direkt aus der Signalquelle mittels einer optischen oder akustischen Ausgabeeinheit gleichzeitig zu den im Massenspeicher gespeicherten Signalen ausgegeben. Die optische Ausgabemöglichkeit wird zum Beispiel bei der Wiedergabe von Navigations-Compact-Discs oder Daten-Compact-Discs eingesetzt, wobei gleichzeitig durch Auslesen des Massenspeichers beispielsweise Musik gehört werden kann.

Bevorzugt wird eine Signalquelle vorgesehen, deren Signale mittels einer optischen oder akustischen Ausgabeeinheit gleichzeitig zu Signalen der Compact-Disc-Abspieleinheit und des Massenspeichers ausgegeben werden. Damit kann zum Beispiel gleichzeitig Musik gehört werden mittels des Massenspeichers und der akustischen Ausgabeeinheit, können Navigationsdaten über Funk empfangen werden mittels der Rundfunkempfangseinheit, können die empfangenen Navigationsdaten anhand von auf einer Compact-Disc gespeicherten Daten ausgewertet werden und anschließend optisch mittels beispielsweise einer Anzeige (Display) dargestellt werden.

Zur besseren Nutzung des Massenspeichers und damit zur Erhöhung der Spielzeit können die Signale der Signalquelle beim Eingeben in den Massenspeicher mittels einer Datenkompressionseinheit komprimiert und bei Ausgabe aus dem Massenspeicher mittels einer Datenkompressionseinheit wieder dekomprimiert werden. Ein geeignetes Kompressionsverfahren ist beispielsweise durch den MP-3 Standard gegeben.

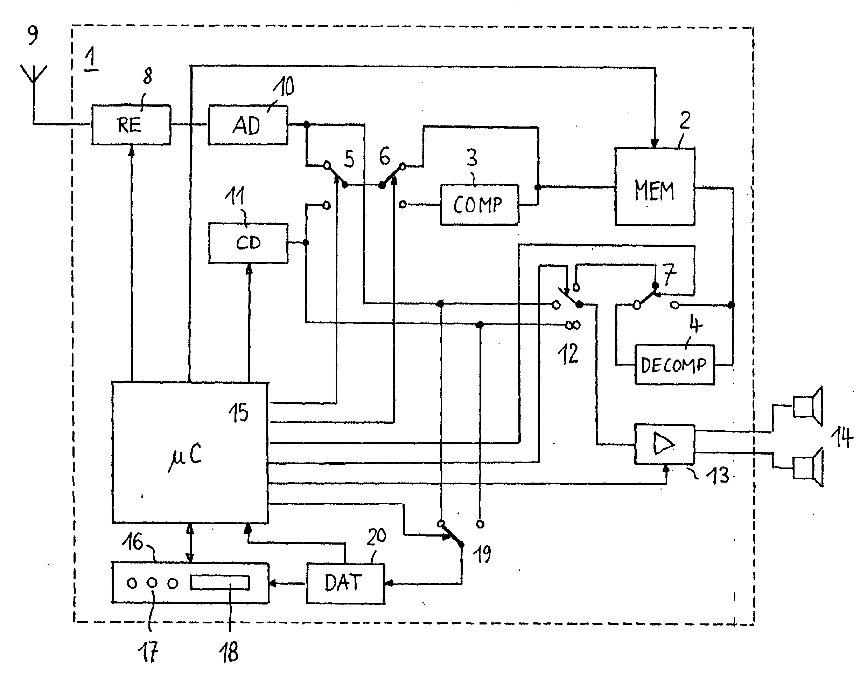

Die Erfindung wird nachfolgend anhand des in der einzigen Figur der Zeichnung dargestellten Ausführungsbeispiels näher erläutert.

Beim Ausführungsbeispiel ist ein herkömmliches Autoradio 1 um einen Massenspeicher 2, eine Datenkompressionseinheit 3, eine Datendekompressionseinheit 4 sowie um diverse Schalteinrichtungen 5, 6, 7 erweitert. Das Autoradio selbst umfaßt eine Rundfunkempfangseinheit 8, die an einer externen Antenne 9 angeschlossen ist. Da beim Ausführungsbeispiel die Rundfunkempfangseinheit 8 analoge niederfrequente Ausgangssignale liefert, ist der Rundfunkempfangseinheit 8 eine Analog-Digital-Umsetzeinheit 10 nachgeschaltet. Bei einer digitale Ausgangssignale bereitstellenden Rundfunkeinheit ist die A/D-Umsetzeinheit 10 nicht nötig. Die Rundfunkempfangseinheit 8 und die Analog-Digital-Umsetzeinheit 10 bilden eine von zwei Signalquellen, von denen die andere Signalquelle durch eine Compact-Disc-Abspieleinheit 11 gegeben ist. Die Ausgänge der Analog-Digital-Umsetzeinrichtung 10 und der Compact-Disc-Abspielvorrichtung 11 sind mit der Schalteinrichtung 5 sowie einer Schalteinrichtung 12 verbunden. Die Schalteinrichtung 5 dient dabei als Signalquellenauswahlschalter für den Massenspeicher 2, während die Schalteinrichtung 12 als Signalquellenauswahlschalter für eine digitale Signale verarbeitende Stereoendstufe 13 vorgesehen ist. An die Stereoendstufe 13 sind dabei zwei externe Lautsprechereinheiten 14 angeschlossen. Dem Massenspeicher 2 ist die Datenkompressionseinheit 3 vorgeschaltet und die Datendekompressionseinheit 4 nachgeschaltet. Sowohl die Datenkompressionseinheit 3 als auch die Datendekompressionseinheit 4 können dabei mittels der Schalteinrichtung 6 bzw. der Schalteinrichtung 7 überbrückt werden, so daß bei entsprechender Stellung der Schalteinrichtung 6 bzw. der Schalteinrichtung 7 keine Datenkompression bzw. Datendekompression stattfindet. Die Rundfunkempfangseinheit 8, die Compact-Disc-Abspieleinheit 11, der Massenspeicher 2, die Stereoendstufe 13 sowie die Schalteinrichtungen 5, 6, 7 und 12 werden dabei durch eine Steuereinheit 15 wie beispielsweise einen Mikrokontroller gesteuert. Die Steuerung durch die Steuereinheit 15 erfolgt dabei in Abhängigkeit von einer Bedieneinheit 16 zur Mensch-Maschine-Kommunikation, die außer zur Eingabe von Informationen mittels entsprechender Bedienelemente 17 (z. B. Tasten, Schalter, Drehknöpfe) auch eine Anzeigeeinheit 18 zur Ausgabe von im Autoradio 1 erzeugten Informationen aufweist. Durch die Steuereinheit 15 werden zudem eine Schalteinrichtung 19 sowie eine Datenauswerteeinheit 20 gesteuert, wobei die Datenauswerteeinheit 20 von ihr erzeugte Daten an die Steuereinheit 15 und die Bedieneinheit 16 weitergibt.

Die durch die Compact-Disc-Abspieleinheit 11 und die Rundfunkempfangseinheit 8 in Verbindung mit der Analog-Digital-Umsetzeinheit 10 gebildeten Signalquellen werden durch die Steuereinheit 15 in Abhängigkeit von über die Bedieneinheit 16 eingegebene Informationen gesteuert derart, daß ein bestimmter zu empfangender Rundfunksender bei der Rundfunkempfangseinheit 8 oder ein bestimmtes Musikstück einer Compact-Disc bei der Compact-Disc-Abspieleinheit 11 ausgewählt wird. Mittels der durch die Steuereinheit 15 gesteuerten Schalteinrichtung 5 kann eine der beiden Signalquellen ebenfalls unter Steuerung der Steuereinheit 15 in den Massenspeicher 2 eingelesen werden. Mittels der ebenfalls durch die Steuereinheit 15 gesteuerten Schalteinrichtung 12 kann eine dieser beiden Signalquellen und zudem der Massenspeicher 2 als Signalquelle ausgewählt werden. Demzufolge ergeben sich insbesondere die folgenden Möglichkeiten:

Es kann beispielsweise eine der beiden Signalquellen auf den Massenspeicher 2 aufgeschaltet sein, während die andere Signalquelle mit der Stereoendstufe 13 und den Lautsprechern 14 gekoppelt ist. In dem Fall kann beispielsweise über die Stereoendstufe 13 und die Lautsprecher 14 ein Radioprogramm über die Rundfunkempfangseinheit 8 gehört werden und gleichzeitig eine in der Compact-Disc-Abspieleinheit 11 befindliche Compact-Disc in den Massenspeicher 2 kopiert werden. In gleicher Weise könnte aber auch eine Rundfunksendung im Massenspeicher 2 abgelegt werden, während über die Stereoendstufe 13 in Verbindung mit den Lautsprechereinheiten 14 die Compact-Disc gehört wird.

Eine andere Betriebsweise sieht vor, daß eine in der Compact-Disc-Abspieleinheit 11 befindliche Compact-Disc über die Stereoendstufe 13 in Verbindung mit den Lautsprechereinheiten 14 abgehört wird und gleichzeitig die Compact-Disc in den Massenspeicher 2 überspielt wird. Darüber hinaus werden gleichzeitig auch über die Rundfunkempfangseinheit 8 empfangene Daten mittels der Datenaufbereitungseinrichtung 20 und der Steuereinheit 15 aufbereitet und über die Anzeigeeinheit 18 der Bedieneinheit 16 dem Anwender optisch dargeboten.

Diese Betriebsweise kann dahingehend abgewandelt werden, daß bereits bei Auswahl bestimmter Daten der Compact-Disc, beispielsweise ein bestimmtes Musikstück, noch vor oder zu Anfang der Vorführung über die Stereoendstufe 13 und die Lautsprechereinheiten 14 in verhältnismäßig kurzer Zeit in den Massenspeicher 2 eingelesen werden. In gleicher Weise könnte aber auch die gesamte Compact-Disc bei Anwahl dieser Compact-Disc in dem Massenspeicher 2 übertragen werden. Nach Übertragung der Daten kann dann beispielsweise die Compact-Disc über die Compact-Disc-Abspieleinheit 11 abgehört werden oder aber aus dem Massenspeicher 2 ausgelesen werden. Werden die Daten aus dem Massenspeicher 2 ausgelesen, dann kann in dem Fall die in der Compact-Disc-Abspieleinheit 11 befindliche Compact-Disc manuell oder automatisch durch einen Wechsler entfernt werden und durch eine andere ersetzt werden. Es kann beispielsweise auch eine andere Compact-Disc eingelegt werden, deren Daten durch die Datenauswerteeinheit 20 in Verbindung mit der Steuereinheit 15 aufbereitet und über die Anzeigeeinheit 18 in der Bedieneinheit 16 an den Anwender ausgegeben werden. Diese andere Compact-Disc kann z. B. eine Bedienungsanleitung, ein Lexikon oder dgl. gespeichert haben.

Neben den beiden gezeigten sind weitere Betriebsweisen durch entsprechende Kombinationen von Schaltzuständen der Schalteinheiten 5 und 12 ebenso möglich. Insbesondere kann vorgesehen werden, daß mehrere Compact-Discs oder mehrere Rundfunksendungen im Massenspeicher 2 abgelegt werden, so daß ein Austausch oder ein Verwahren von Compact-Discs im Fahrzeug unterbleiben kann.

Als Massenspeicher 2 können insbesondere Hard-Discs, Memory-Sticks, dynamische Speicher (z. B. DRAM), EEPROMs (insbesondere Flash-EEPROM) oder beliebige andere Speichermedien eingesetzt werden. Um den Speicherplatz im Massenspeicher 2 wirtschaftlich zu nutzen, wird eine entsprechende Kompressions-/Dekompressions-Einrichtung in Form der Datenkompressionseinheit 3 und der Datendekompressionseinheit 4 vorgesehen. Diese können beispielsweise nach dem MP-3-Standard arbeiten.

### Bezugszeichenliste

- 1: Autoradio
- 2: Massenspeicher
- 3: Datenkompressionseinheit
- 4: Datendekompressionseinheit
- 5: Schalteinrichtung
- 6: Schalteinrichtung
- 7: Schalteinrichtung
- 8: Rundfunkempfangseinheit
- 9: Antenne
- 10: Analog-Digital-Umsetzeinheit
- 11: Compact-Disc-Abspielvorrichtung
- 12: Schalteinrichtung
- 13: Stereoendstufe
- 14: Lautsprechereinheiten
- 15: Steuereinheit
- 16: Bedieneinheit
- 17: Bedienelemente
- 18: Anzeigeeinheit
- 19: Schalteinrichtung
- 20: Datenauswerteeinheit

## Patentansprüche

1. Wiedergabevorrichtung für ein Kraftfahrzeug mit
einer Compact-Disc-Abspieleinheit (11) zum Erzeugen digitaler Signale,
einem mit der Compact-Disc-Abspieleinheit (11) verbundenen Massenspeicher (2) zum Speichern digitaler Signale,
einem Bedienteil (16) zur Mensch-Maschine-Kommunikation und
einer Ablaufsteuerung (15) zum Steuern der Compact-Disc-Abspieleinheit (11) und des Massenspeichers (2) in Abhängigkeit von in das Bedienteil (16) eingegebenen Informationen derart,
daß beim Betrieb der Compact-Disc-Abspieleinheit (11) die von dieser erzeugten digitalen Signale in dem Massenspeicher (2) speicherbar sind,
daß die Signale aus der Compact-Disc-Abspieleinheit (11) oder aus dem Massenspeicher (2) mittels einer akustischen und/oder optischen Ausgabeeinheit (13, 14, 18) ausgebbar sind, und
daß die Signale der Compact-Disc-Abspieleinheit (11) zunächst in den Massenspeicher (2) übertragen werden, diese gespeicherten Signale dann mittels der akustischen Ausgabeeinheit (13, 14, 18) aus dem Massenspeicher (2) ausgegeben werden und weitere Signale der Compact-Disc-Abspieleinheit direkt aus der Compact-Disc-Abspieleinheit (11) mittels einer optischen oder akustischen Ausgabeeinheit (13, 14, 18) gleichzeitig zu den gespeicherten Signalen ausgegeben werden.

2. Wiedergabevorrichtung nach Anspruch 1, bei der eine Signalquelle (8, 10, 11) vorgesehen ist, deren Signale mittels einer optischen oder akustischen Ausgabeeinheit (13, 14, 18) gleichzeitig zu Signalen der Compact-Disc-Abspieleinheit (11) oder des Massenspeichers (2) ausgegeben werden.

3. Wiedergabevorrichtung nach einem der Ansprüche 1 oder 2, bei der die Signale der Compact-Disc-Abspieleinheit (11) beim Eingeben in den Massenspeicher (2) mittels einer Datenkompressionseinheit (3) komprimiert und bei Ausgabe aus dem Massenspeicher (2) mittels einer Datenkompressionseinheit (4) dekomprimiert werden.

4. Wiedergabevorrichtung nach einem der Ansprüche 2 bis 3, bei der die Signalquelle durch eine Rundfunkempfangseinheit (8, 10) gebildet wird.

5. Wiedergabevorrichtung nach einem der Ansprüche 2 bis 3, bei der die Signalquelle durch eine Telefon- oder Internetempfangseinheit gebildet wird.

## Claims

1. A reproduction device for a motor vehicle including a compact disk play-back unit (11) for producing digital signals, a bulk store (2) connected to the compact disk play-back unit (11) for storing digital signals, a control element (16) for person-machine communication and a sequence controller (15) for controlling the compact disk play-back unit (11) and the bulk store (2) in dependence on the information input into the control element such that, in operation of the compact disk play-back unit (11), the digital signals produced by it are storable in the bulk store (2), that the signals from the compact disk play-back unit (11) or from the bulk store (2) may be output by means of an acoustic and/or optical output unit (13,14, 18) and that the signals from the compact disk play-back unit (11) are firstly transferred into the bulk store (2), these stored signals are then output from the bulk store (2) by means of the acoustic output unit (13, 14, 18) and further signals from the compact disk play-back unit are output directly from the compact disk play-back unit (11) by means of an optical or acoustic output unit (13, 14, 18) at the same time as the stored signals.

2. A reproduction device as claimed in Claim 1, in which a signal source (8, 10, 11) is provided, the signals from which are output by means of an optical or acoustic output unit (13, 14, 18) at the same time as signals from the compact disk play-back unit (11) of the bulk store (2).

3. A reproduction device as claimed in one of Claims 1 or 2, in which the signals from the compact disk play-back unit (11) are compressed when input into the bulk store (2) by means of a data compression unit (3) and are decompressed on output from the bulk store (2) by means of a data compression unit (4).

4. A reproduction device as claimed in one of Claims 2 to 3, in which the signal source is constituted by a radio receiving unit (8, 10).

5. A reproduction device as claimed in one of Claims 2 to 3, in which the signal source is constituted by a telephone or internet receiving unit.

## Revendications

1. Système de reproduction pour un véhicule automobile avec une unité de lecture de disques compacts (11) pour produire des signaux numériques,
une mémoire de masse (2) reliée à l'unité de lecture de disques compacts (11) pour stocker des signaux numériques,
une partie de commande (16) pour la communication hommeNmachine et
une commande de lecture (15) pour commander l'unité de lecture de disques compacts (11) et la mémoire de masse (2) en fonction d'informations entrées dans la partie de commande (16), de manière à ce que
lors du fonctionnement de l'unité de lecture de disques compacts (11), les signaux produits par celleNci puissent être stockés dans la mémoire de masse (2), que les signaux de l'unité de lecture de disques compacts (11) ou de la mémoire de masse (2) puissent être restitués au moyen d'une unité de sortie acoustique et/ou optique (13, 14, 18), et
que les signaux de l'unité de lecture de disques compacts (11) soient d'abord transmis dans la mémoire de masse (2), ces signaux stockés sont alors restitués depuis la mémoire de masse (2) au moyen de l'unité de sortie acoustique (13, 14, 18) et d'autres signaux de l'unité de lecture de disques compacts sont restitués simultanément aux signaux stockés directement depuis l'unité de lecture de disques compacts (11) au moyen d'une unité de sortie acoustique ou optique (13, 14, 18).

2. Système de reproduction selon la revendication 1, dans lequel une source de signal (8, 10, 11) est prévue dont les signaux sont restitués simultanément aux signaux de l'unité de lecture de disques compacts (11) ou de la mémoire de masse (2) au moyen d'une unité de sortie acoustique ou optique (13, 14, 18).

3. Système de reproduction selon la revendication 1 ou 2, dans lequel les signaux de l'unité de lecture de disques compacts (11) sont compressés au moyen d'une unité de compression de données (3) lors de l'entrée dans la mémoire de masse (2) et sont décompressés au moyen d'une unité de compression de données (4) lors de la sortie de la mémoire de masse (2).

4. Système de reproduction selon l'une des revendications 2 à 3, dans lequel la source de signal est formée par une unité de réception de radiodiffusion (8, 10).

5. Système de reproduction selon l'une des revendications 2 à 3, dans lequel la source de signal est formée par une unité de réception téléphonique ou d'accès internet.
